# EUROPEAN PATENT APPLICATION

(11) **EP 4 578 990 A1**
(43) Date of publication of application: **02.07.2025**
(21) Application number: 23857163.2
(22) Date of filing: 07.08.2023
(51) Int. Cl.: C23C 16/40, C30B 25/18, C30B 29/16, H01L 21/365, H01L 21/368

(54) **FILM DEPOSITION METHOD, FILM DEPOSITION DEVICE, AND ALFA-GA2O3 FILM**

(30) Priority: 25.08.2022 JP 2022133765
(71) Applicant: SHIN-ETSU CHEMICAL CO., LTD., Tokyo 1000005 (JP)
(72) Inventor: WATABE Takenori, Annaka-shi, Gunma 379-0195 (JP)
(74) Representative: Sonnenhauser, Thomas Martin
(86) International application number: PCT/JP2023/028697
(87) International publication number: WO 2024/043049

(57) **Abstract**

The present invention is a film-forming method for forming a crystalline oxide film by a mist-CVD method, the method including: supplying a mist together with a carrier gas onto a heated substrate in a film-forming member covered with a partition wall, wherein, in at least heating the substrate, a gas other than the carrier gas is fed into the film-forming member. This provides a film-forming method to form a high-quality crystalline oxide film having a remarkably reduced particle density on a film surface.

## Description

### TECHNICAL FIELD

The present invention relates to a film-forming method, a film-forming apparatus, and an α-Ga₂O₃ film.

### BACKGROUND ART

There has been development of mist chemical vapor deposition (which may be also referred to as "the mist-CVD method") in which an atomized raw material into a mist is used for forming a thin film on a substrate. The mist-CVD method has been used for production of an oxide semiconductor film, etc. (Patent Documents 1 and 2).

### CITATION LIST

### PATENT LITERATURE

Patent Document 1: JP 2013-028480 A
Patent Document 2: JP 2014-063973 A
Patent Document 3: JP 2021-136445 A

### SUMMARY OF INVENTION

### TECHNICAL PROBLEM

In the mist-CVD method, however, the mist is flocculated in a film-forming chamber or a product adhering to a wall surface is released or floated, which become a particle generation source. Since the mist-CVD method is originally a film-forming method of supplying the mist, namely particles, special attention has not been paid to the particles. In addition, no method of atomizing a raw material into a mist for forming a high-quality film has been established so far. There is a problem that a large amount of the particles derived from the quality of the raw material mist as above adhere to the produced film. It is known that increase in the amount of the supplied mist for increasing a film-forming rate etc. causes such particle adhesion to be more considerable, and achievement of both the film quality and productivity is challenging.

For such a challenge, for example, Patent Document 3 discloses a method for inhibiting particle generation by controlling an atomizing method. However, lengthening the film-forming time with thickening the film causes flocculation of the mist in the film-forming chamber or release or floating of the product adhering to a wall surface of the film-forming chamber etc. to be a new particle generation source.

In addition, a pressure in the film-forming chamber is commonly negative for dispersing the mist in the film-forming chamber. Accordingly, there is a problem that not a few amount of external air flows from the outside of the film-forming chamber to contaminate the film due to particles in the external air.

The present invention has been made to solve the above problems. An object of the present invention is to provide a film-forming method and a film-forming apparatus that form a high-quality crystalline oxide film with a remarkably reduced particle density on the film surface.

In addition, an object of the present invention is to provide a high-quality α-Ga₂O₃ film with a remarkably reduced particle density on the film surface.

### SOLUTION TO PROBLEM

The present invention has been made to achieve the above objects, and provides a film-forming method for forming a crystalline oxide film by a mist-CVD method, the method including: supplying a mist together with a carrier gas onto a heated substrate in a film-forming member covered with a partition wall, wherein, in at least heating the substrate, a gas other than the carrier gas is fed into the film-forming member.

The film-forming method as above can yield a high-quality semiconductor film with a remarkably reduced particle density on the film surface.

In this case, in not supplying the mist, a density of particles having a particle diameter of 0.3 µm or more in the film-forming member is preferably 100000 /m³ or less.

The film-forming method as above can yield a high-quality semiconductor film with a more remarkably reduced particle density on the film surface.

In this case, air is preferably used as the gas other than the carrier gas.

The film-forming method as above can produce the crystalline oxide film inexpensively, and has excellent safety in producing the crystalline oxide film.

The present invention has been made to achieve the above objects, and provides a film-forming method for forming a crystalline oxide film by a mist-CVD method, the method including: supplying a mist together with a carrier gas onto a heated substrate in a film-forming member covered with a partition wall, wherein, in at least not supplying the mist, a density of particles having a particle diameter of 0.3 µm or more in the film-forming member is 100000 /m³ or less.

In this case, a gas-discharging member is preferably provided so as to surround the film-forming member, and a gas is preferably discharged from the film-forming member through the gas-discharging member.

The film-forming method as above can simplify the producing apparatus, and has excellent safety.

In this case, a flow rate of the gas discharged through the gas-discharging member is preferably larger than a flow rate of the carrier gas.

The film-forming method as above has more excellent safety, and can yield a high-quality semiconductor film with an extremely reduced surface defect density, not only particles.

In this case, a substrate having a diameter of 4 inch (100 mm) to 8 inch (200 mm) is preferably used as the substrate.

The film-forming method as above can yield a high-quality semiconductor film with a more remarkably reduced particle density on the film surface also on a large-area substrate.

The present invention has been made to solve the above problems, and provides a film-forming apparatus including: a film-forming member covered with a partition wall; a carrier gas-supplying member; and a mist-generating member configured to generate a mist, wherein the film-forming apparatus is configured to supply the mist together with a carrier gas into the film-forming member and to form a film, and a gas-feeding member is provided on the film-forming member for feeding a gas other than the carrier gas.

The film-forming apparatus as above can perform the aforementioned film-forming method, and can yield a high-quality semiconductor film with a remarkably reduced particle density on the film surface. In addition, the film-forming apparatus as above can produce the crystalline oxide film inexpensively, and has excellent safety in producing the crystalline oxide film.

In this case, a filter is preferably provided on the gas-feeding member.

The film-forming apparatus as above can yield a high-quality semiconductor film with a more remarkably reduced particle density on the film surface.

In this case, a gas-discharging member is preferably provided so as to surround the film-forming member, and a gas is preferably discharged from the film-forming member through the gas-discharging member.

The film-forming apparatus as above can achieve simplification, and has excellent safety.

In this case, the gas-feeding member is preferably configured to feed air as the gas other than the carrier gas.

The film-forming apparatus as above can produce the crystalline oxide film inexpensively, and has excellent safety in producing the crystalline oxide film.

The present invention has been made to solve the above problems, and provides an α-Ga₂O₃ film having a film-thickness variation of 3.3% or less and particles on the film at 29 /cm² or less, the particles being observed with an optical microscope.

The α-Ga₂O₃ film as above has excellent film-thickness distribution, and inhibited contamination inside the film with a foreign matter. Thus, the α-Ga₂O₃ film is a high quality film with a remarkably reduced particle density on the film surface, which is suitable for producing a semiconductor device.

In this case, a half-value width of a rocking curve on a (006) plane by X-ray diffraction is preferably 8 seconds or less.

The α-Ga₂O₃ film as above has good crystallinity.

In this case, the film preferably has a diameter of 4 inch (100 mm) to 8 inch (200 mm).

The α-Ga₂O₃ film as above is a high quality film with a more remarkably reduced particle density on the film surface also on a large-area substrate.

### ADVANTAGEOUS EFFECTS OF INVENTION

As noted above, the film-forming method of the present invention can yield a high-quality crystalline oxide film with a remarkably reduced particle density on the film surface.

The film-forming apparatus of the present invention can yield a high-quality crystalline oxide film with a remarkably reduced particle density on the film surface.

The α-Ga₂O₃ film of the present invention is a high quality film with a remarkably reduced particle density on the film surface.

### BRIEF DESCRIPTION OF DRAWINGS

FIG. 1 is a schematic diagram illustrating an example of a film-forming apparatus of the present invention;
FIG. 2 is a schematic diagram illustrating an example of a semiconductor device using a laminated structure produced with a film-forming method and film-forming apparatus of the present invention;
FIG. 3 is a schematic diagram illustrating another example of a film-forming member of a film-forming apparatus of the present invention;
FIG. 4 is a schematic diagram illustrating further another example of a film-forming member of a film-forming apparatus of the present invention;
FIG. 5 is a schematic diagram illustrating furthermore another example of a film-forming member of a film-forming apparatus of the present invention; and
FIG. 6 is a schematic diagram illustrating still furthermore another example of a film-forming member of a film-forming apparatus of the present invention.

### DESCRIPTION OF EMBODIMENTS

Hereinafter, the present invention will be described in detail, but the present invention is not limited thereto.

As noted above, there has been a demand for a film-forming method and a film-forming apparatus that can yield a high-quality crystalline oxide film with a remarkably reduced particle density on the film surface.

The present inventor has earnestly studied the above objects, and consequently found that the high-quality crystalline oxide film with a remarkably reduced particle density on the film surface can be obtained by: a film-forming method for forming a crystalline oxide film by a mist-CVD method, the method including: supplying a mist together with a carrier gas onto a heated substrate in a film-forming member covered with a partition wall, wherein, in at least heating the substrate, a gas other than the carrier gas is fed into the film-forming member; or a film-forming method for forming a crystalline oxide film by a mist-CVD method, the method including: supplying a mist together with a carrier gas onto a heated substrate in a film-forming member covered with a partition wall, wherein, in at least not supplying the mist, a density of particles having a particle diameter of 0.3 µm or more in the film-forming member is 100000 /m³ or less. The present inventor has also found that the high-quality crystalline oxide film with a remarkably reduced particle density on the film surface can be obtained by a film-forming apparatus including: a film-forming member covered with a partition wall; a carrier gas-supplying member; and a mist-generating member configured to generate a mist, wherein the film-forming apparatus is configured to supply the mist together with a carrier gas into the film-forming member and to form a film, and a gas-feeding member is provided on the film-forming member for feeding a gas other than the carrier gas. These findings have led to completion of the present invention.

As noted above, there has been a demand for a high-quality α-Ga₂O₃ film with a remarkably reduced particle density on the film surface.

The present inventor has earnestly studied the above objects, and consequently found that an α-Ga₂O₃ film having a film-thickness variation of 3.3% or less and particles on the film at 29 /cm² or less, the particles being observed with an optical microscope, is the high-quality α-Ga₂O₃ film with a remarkably reduced particle density on the film surface. This finding has led to completion of the present invention.

### (First Embodiment of the Present Invention)

### (Film-Forming Apparatus)

Hereinafter, a film-forming method and a film-forming apparatus according to the first embodiment of the present invention will be described.

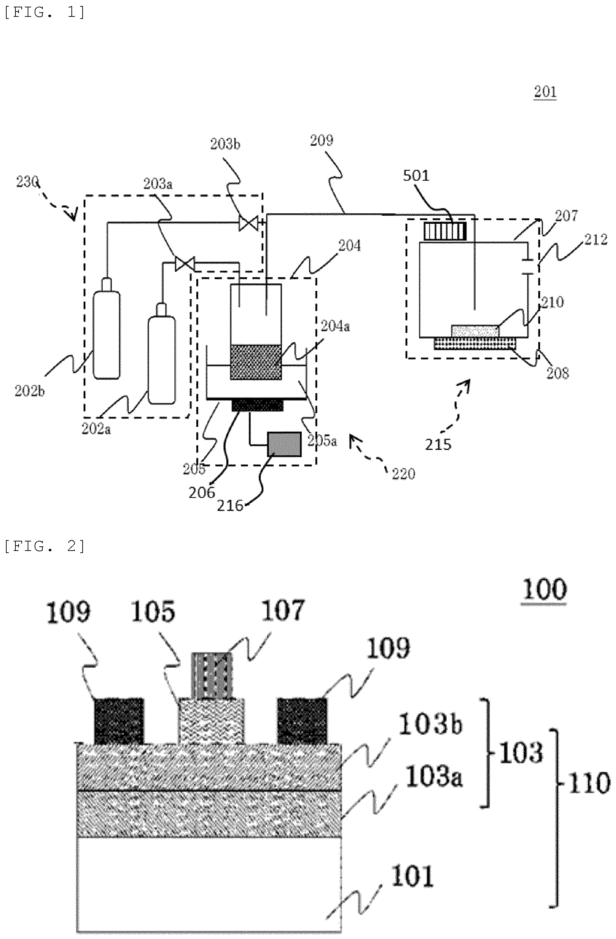

FIG. 1 is a schematic diagram illustrating an example of the film-forming apparatus of the present invention.

As illustrated in FIG. **1****,** a film-forming apparatus 201 of the present invention has a film-forming member 215 covered with a partition wall (a film-forming chamber) 207, a carrier gas-supplying member 230, and a mist-generating member 220 configured to generate a mist.

### (Mist-Generating Member)

The mist-generating member 220 atomizes a raw material solution 204a to generate a mist.

The term "mist" in the present invention generally refers to fine liquid particles dispersed in gas, and encompasses materials called fog, droplet, etc.

The mist-generating means is not particularly limited as long as the means can atomize the raw material solution 204a into a mist. The mist-generating means may be a known means, but a mist-generating means with ultrasonic vibration is preferably used. This is because the mist can be more stably generated.

As illustrated in FIG. 1, the mist-generating member 220 has: a mist-generating source 204 to contain the raw material solution 204a; a container 205 to contain a medium that can propagate ultrasonic vibration, for example, water 205a; and an ultrasonic vibrator 206 attached to a bottom of the container 205. In detail, the mist-generating source 204 composed of the container containing the raw material solution 204a is contained in the container 205 containing water 205a by using a support (not illustrated). The ultrasonic vibrator 206 is provided on the bottom of the container 205, and the ultrasonic vibrator 206 and an oscillator 216 are coupled. The mist-generating member 220 is configured such that, when the oscillator 216 is operated, the ultrasonic vibrator 206 vibrates to propagate ultrasonic wave in the mist-generating source 204 via water 205a, and to atomize the raw material solution 204a into a mist.

### (Raw Material Solution)

A material contained in the raw material solution 204a is not particularly limited as long as the material can be atomized into a mist, and may be an inorganic material or an organic material. As the material, a metal or a metal compound is suitably used, and for example, a material containing one or two or more metals selected from gallium, iron, indium, aluminum, vanadium, titanium, chromium, rhodium, nickel, and cobalt may be used. As the aforementioned raw material solution, a solution in which the metal is dissolved or dispersed in an organic solvent or water as a complex form or a salt form can be suitably used. Examples of the salt form include a metal halide salt such as a metal chloride salt, a metal bromide salt, and a metal iodide salt. A solution in which the metal is dissolved in a hydrogen halide such as hydrobromic acid, hydrochloric acid, and hydroiodic acid may also be used as the salt solution. Examples of the complex form include an acetylacetonate complex, a carbonyl complex, an ammine complex, and a hydride complex. The acetylacetonate complex may also be formed by mixing acetylacetone with the aforementioned salt solution. A metal concentration in the raw material solution 204a is not particularly limited, and may be 0.005 to 1 mol/L. Temperatures in mixing and dissolving are preferably 20°C or higher.

Into the raw material solution 204a, an additive such as a hydrohalic acid and an oxidant may be mixed. Examples of the hydrohalic acid include hydrobromic acid, hydrochloric acid, and hydroiodic acid. Among these, hydrobromic acid or hydroiodic acid is preferable because a high film-forming rate can be obtained. Examples of the oxidant include: peroxides such as hydrogen peroxide (H₂O₂), sodium peroxide (Na₂O₂), barium peroxide (BaO₂), and benzoyl peroxide (C₆H₅CO)₂O₂, hypochlorous acid (HClO), perchloric acid, nitric acid, and ozone water; and organic peroxides such as peracetic acid and nitrobenzene.

The raw material solution 204a may contain a dopant source. The dopant source is not particularly limited. Examples thereof include: n-type dopant sources such as tin, germanium, silicon, titanium, zirconium, vanadium, or niobium; and p-type dopant sources such as copper, silver, iridium, rhodium, or magnesium.

### (Carrier Gas-Supplying Member)

The carrier gas-supplying member 230 supplies a carrier gas for carrying the mist.

As illustrated in FIG. 1, the carrier gas-supplying member 230 has: a carrier gas source 202a to supply the carrier gas; and a flow-rate regulating valve 203a for regulating a flow rate of the carrier gas fed from the carrier gas source 202a. The carrier gas-supplying member 230 also has a dilution carrier gas source 202b and a flow-rate regulating valve 203b for regulating a flow rate of the dilution carrier gas fed from the dilution carrier gas source 202b. This configuration can supply the dilution carrier gas as necessary, in addition to the carrier gas. In the present invention, a sum of the flow rate of the carrier gas and the flow rate of the dilution carrier gas is called "the total flow rate of the carrier gas".

A type of the carrier gas is not particularly limited, and may be appropriately selected depending on the film to be formed. Examples thereof include oxygen, ozone, an inert gas such as nitrogen and argon, and a reductive gas such as hydrogen gas and forming gas. A number of types of the carrier gas may be one, or two or more. For example, a diluted gas in which a gas same as a first carrier gas is diluted with another gas (for example, diluted to 10 times) may be further used as a second carrier gas, and air may also be used. A flow rate of the total carrier gas is not particularly limited. For example, when a film is formed on a substrate with 2 inch (about 50 mm) in diameter, the flow rate of the total carrier gas is preferably set to 0.05 to 50 NL/min, and more preferably set to 5 to 20 NL/min. Note that "NL" refers to a value of a volume of the gas converted into the standard state (0°C, 1 atm).

### (Supplying Pipe)

A supplying pipe 209 couples the mist-generating member 220 and the film-forming member 215 to carry the mist with the carrier gas. The mist is carried from the mist-generating source 204 of the mist-generating member 220 through the supplying pipe 209 with the carrier gas to be supplied into the film-forming member 215.

As the supplying pipe 209, a quartz pipe, a glass pipe, a resin tube, etc. may be used, for example. A tip of the supplying pipe 209 has a nozzle.

### (Film-Forming Member)

FIG. 1 is a diagram illustrating an example of the film-forming member of the film-forming apparatus of the present invention.

As illustrated in FIG. 1, the film-forming member 215 is a portion being approximately entirely covered with the partition wall (the film-forming chamber) 207.

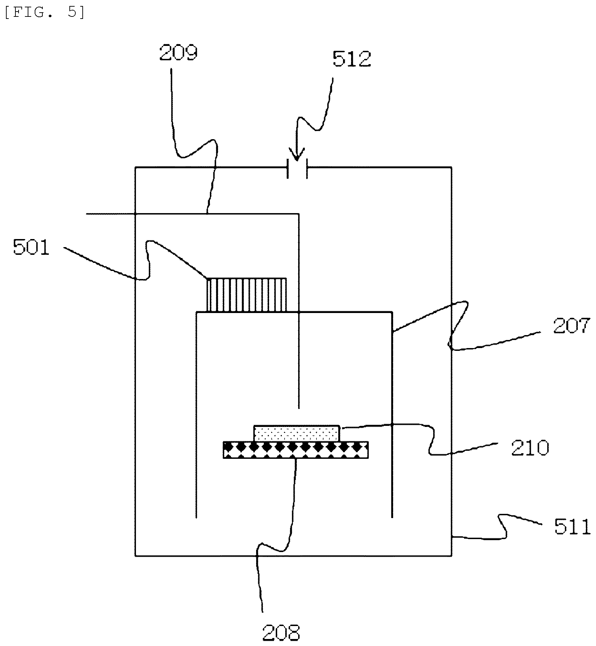

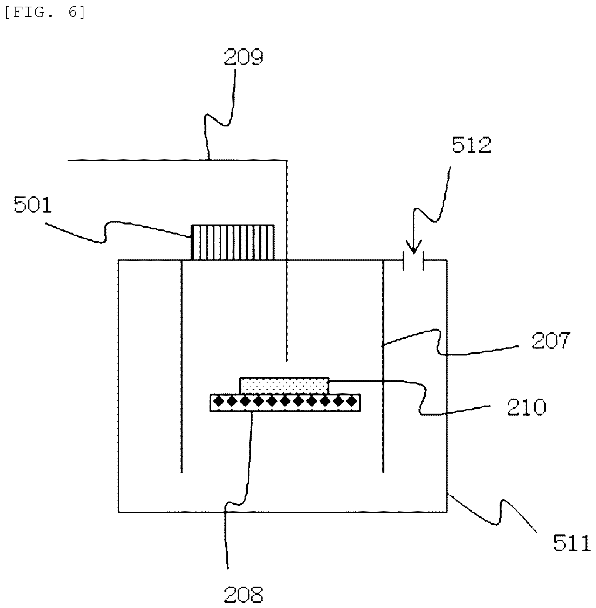

The configuration "approximately entirely covered" may be a configuration in which a region including the substrate is completely covered with the partition wall as illustrated in FIG. 1, FIG. 3, and FIG. 4, or may be a configuration in which a part of the surfaces is opened as illustrated in FIG. 5 and FIG. 6.

A material of the partition wall (the film-forming chamber) 207 may be a metal such as iron, aluminum, and stainless steel, or may be a resin such as acryl and vinyl chloride. The resin material can reduce the weight of the apparatus, and reduce the cost of the apparatus. Use of the transparent material enables to visually observe the state during the film formation, which easily prevent apparatus troubles.

A substrate 210 is placed in the partition wall (the film-forming chamber) 207, and the partition wall (the film-forming chamber) 207 has a heater 208 for heating the substrate 210. For example, the heater 208 may be provided outside the partition wall (the film-forming chamber) 207 as illustrated in FIG. 1, or may be provided inside the partition wall (the film-forming chamber) 207 as illustrated in FIG. 5 and FIG. 6, for example.

The film-forming member 207 is configured such that the mist can be introduced thereinto together with the gas (carrier gas) for forming the film, supplied through the supplying pipe 209. The mist is jetted together with the carrier gas through the nozzle toward the substrate 210, and the mist is thermally treated on the substrate 210 to form the film.

A top plate for rectifying the supplied mist above the substrate may be provided.

On the partition wall (the film-forming chamber) 207, a gas-feeding member 501 for feeding a gas other than the carrier gas is provided.

### (Gas-Feeding Member)

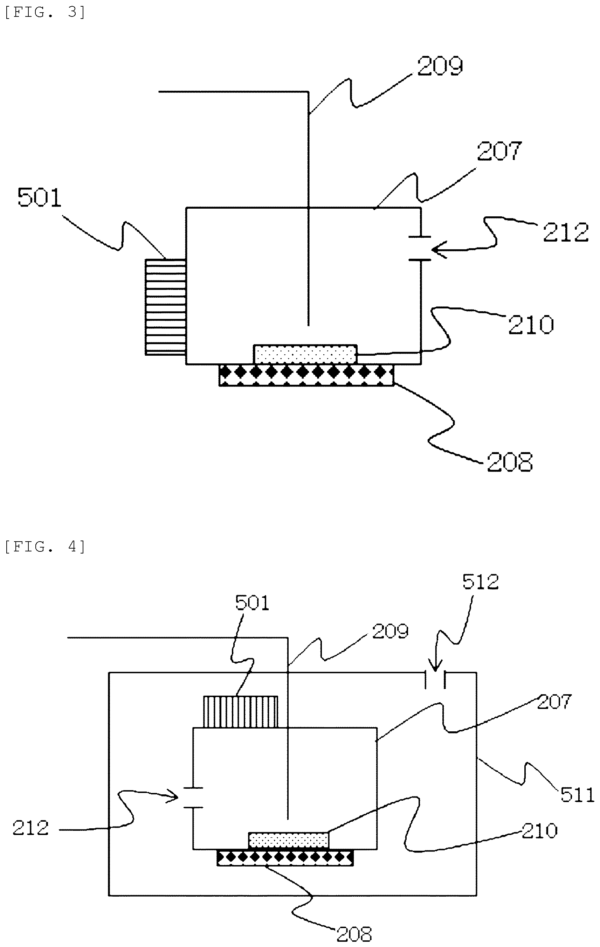

In the present invention, the gas-feeding member 501 for feeding a gas other than the carrier gas, for example, air, separately from the carrier gas for forming the film into the partition wall (the film-forming chamber) 207 is coupled. The gas to be fed is not particularly limited. Examples thereof include an inert gas in addition to air, but air is particularly preferable. The gas-feeding member 501 may be present vertically above the substrate 210 as in FIG. 1, or may be present on a lateral side of the substrate 210 as in FIG. 3. In the gas-feeding member 501, a filter may be provided. Use of a high-performance filter such as HEPA may increase cleanness in the film-forming member. Feeding the gas from the gas-feeding member 501 can regulate an aerial particle density with a particle diameter of 0.3 µm or more in the film-forming member to 100000 /m³ or less. Since a lower particle density is better, the lower limit thereof is 0 /m³. The aerial particles in this case can be measured with a commercially available particle counter using a light scattering method. A light interrupting method may be used, but the light scattering method is more common and preferable. The particle counter may be constantly provided on the film-forming apparatus, or a mechanism of constantly monitoring the particle density in the film-forming member and then judging whether the film can be formed based on the measured particle density may be provided. An upper limit of the diameter of the particle is not particularly limited, and is 1000 µm, for example.

### (Gas-Discharging Port)

On the partition wall (the film-forming chamber) 207, a gas-discharging port 212 for discharging gas may be provided. In FIG. 5 and FIG. 6, the opened surface of the partition wall can be regarded as the large gas-discharging port.

### (Gas-Discharging Member)

A gas-discharging member may be provided so as to surround the partition wall (the film-forming chamber) 207. In the examples illustrated in FIG. 4 to FIG. 6, a gas-discharging member 511 surrounds the partition wall (the film-forming chamber) 207. As in FIG. 6, a part of the partition wall (the film-forming chamber) 207 and a part of an outer wall of the gas-discharging member 511 may be common. The gas-discharging member 511 has one or more gas-discharging ports 512 on the gas-discharging member, and coupled to a fan, etc. to forcedly discharge gas thereinside. It is enough if the gas-discharging member 511 can discharge gas for the purpose, and need not completely sealed.

### (Substrate)

The substrate 210 is a base substrate for forming the crystalline oxide film. The substrate 210 is not particularly limited as long as the substrate is a support for the crystalline oxide film. A material thereof is not particularly limited, and known substrates may be used. The material may be an organic compound or an inorganic compound. Examples thereof include polysulfone, polyether sulfone, polyphenylene sulfide, polyether ether ketone, polyimide, polyether imide, a fluororesin, metals such as iron, aluminum, stainless steel, and gold, quartz, glass, calcium carbonate, gallium oxide, and ZnO. In addition to the above, examples of the substrate also include single-crystal substrates made of silicon, sapphire, lithium tantalate, lithium niobate, SiC, GaN, iron oxide, chromium oxide, etc., and the single-crystal substrates as the above are desirable in the present invention. These single-crystal substrates can yield a crystalline oxide film with better quality. In particular, a sapphire substrate, a lithium tantalate substrate, and a lithium niobate substrate are relatively inexpensive and industrially advantageous.

A thickness of the substrate 210 is preferably 100 to 5000 µm. Within this range, handling is facilitated, and a film with good quality is easily obtained because thermal resistance can be inhibited during the film formation.

A size of the substrate 210 is not particularly limited, but a substrate having an area of 100 mm² or more or a diameter of 2 inch (50 mm) or more is preferable because a large-area film with good crystallinity is obtained. Further, setting a diameter of the substrate to 4 inch (100 mm) to 8 inch (200 mm) facilitates processing of the obtained crystalline oxide film using an existing processing apparatus, which is industrially advantageous in the semiconductor device production. In addition, such a film has the large area and excellent film thickness distribution, and yields excellent semiconductor properties when applied for semiconductor devices. For example, when semiconductor devices such as power semiconductor devices are produced from the crystalline oxide film as above, the production lot having two or more of the semiconductor devices can provide a breakdown voltage yield of 75% or more.

Between the substrate 210 and the crystalline oxide film, another layer may be interposed. The other layer is a layer having different composition from the substrate and the crystalline oxide film on the outermost layer, and also called "buffer layer". The buffer layer may be any of an oxide semiconductor film, an insulative film, a metal film, etc., and as a material, Al₂O₃, Ga₂O₃, Cr₂O₃, Fe₂O₃, In₂O₃, Rh₂O₃, V₂O₃, Ti₂O₃, Ir₂O₃, etc. are preferably used, for example. A thickness of the buffer layer is preferably 0.1 µm to 2 µm.

In FIG. 1, the substrate 210 is placed on the bottom surface of the partition wall (the film-forming chamber) 207 to be arranged as face-up. The substrate 210, however, may be placed on the upper surface of the partition wall (the film-forming chamber) 207 to be arranged as face-down.

The heater 208 or the nozzle may be coupled to a conveying mechanism to form a movable configuration such as reciprocating motion and rotating motion. Performing these moving operations during the film formation improves uniformity of the obtained film.

### (Film-Forming Method)

The film-forming method of the present invention will be described.

The film-forming method of the present invention is a film-forming method for forming a crystalline oxide film by a mist-CVD method, the method including: supplying a mist together with a carrier gas onto the heated substrate 210 in the film-forming member 215 covered with the partition wall (the film-forming chamber) 207, wherein, in at least heating the substrate 210, a gas other than the carrier gas is fed into the film-forming member 215.

More specifically, the film-forming method of the present invention includes: a mist-generating step of atomizing a raw material solution into a mist to generate the mist in a mist-generating member 220; a carrier gas-supplying step of supplying a carrier gas into the mist-generating member 220, the carrier gas being for carrying the mist; a carrying step of carrying the mist with the carrier gas from the mist-generating member 220 to a film-forming member 215 through a supplying pipe 209 coupling the mist-generating member 220 and the film-forming member 215; and a film-forming step of thermally treating the carried mist and forming a film on the base substrate (substrate) 210.

First, the substrate 210 is placed in the film-forming member 215 approximately entirely covered with the partition wall (the film-forming chamber) 207, and the heater 208 is operated. In at least heating the substrate, the gas other than the carrier gas is fed. A flaw rate of feeding the gas may be 20 to 10000 NL/min. For example, air may be fed through the gas-feeding member 501. In at least not supplying the mist, a density of particles having a particle diameter of 0.3 µm or more in the film-forming member 215 is preferably 100000 /m³ or less. For example, nitrogen may be fed through the gas-feeding member 501. In this case, a diffuser (a diffusing plate), etc. may be provided so that the gas is widely diffused in the film-forming chamber.

Although the cleanness in the film-forming member 215 can be increased by feeding a large amount of the carrier gas, a typical flow rate of the carrier gas is small to yield a limited effect. The carrier gas is commonly pressurized or purified excessively, and flowing a large amount of this carrier gas increases the cost.

The gas may be forcedly discharged through the gas-discharging port 212. In this case, a flow rate of discharging through the gas-discharging port 212 is desirably smaller than or equal to the flow rate of feeding through the gas-feeding member 501. This is because a large gas-discharging flow rate causes external air to flow into the film-forming member 207 to decrease the cleanness.

Further, in a case of having the gas-discharging member 511 as in FIG. 4 to FIG. 6, a gas-discharging fan, etc. may be operated to discharge the gas in the gas-discharging member 511. The pressure inside the gas-discharging member 511 (a region excluding the partition wall (the film-forming chamber) 207) is lower than the pressure outside the gas-discharging member 511, and the pressure difference is preferably set to about 0.1 to 100 Pa.

The flow rate of the gas discharged through the gas-discharging member 511 is preferably larger than a flow rate of the carrier gas. This setting has more excellent safety, and can yield a high-quality semiconductor film with an extremely reduced surface defect density, not only particles.

### (Mist-Generating Step)

In the mist-generating step, a raw material solution 204a is contained in a mist-generating source 204, an ultrasonic wave vibrator 206 is vibrated, and the vibration is propagated through water 205a to the raw material solution 204a to atomize the raw material solution 204a into a mist to generate the mist.

### (Carrier Gas-Supplying Step)

In the carrier gas-supplying step, the carrier gas for carrying the mist and the dilution carrier gas are supplied into the mist-generating member 220.

Note that flow-rate regulating valves 203a and 203b are opened to supply the carrier gas and the dilution carrier gas into the film-forming member 215 from a carrier gas source 202a and a dilution carrier gas source 202b, the atmosphere in the film-forming member 215 is sufficiently substituted with the carrier gas and the dilution carrier gas, and then the flow rate of the carrier gas and the flow rate of the dilution carrier gas are each regulated.

### (Carrying Step)

As the carrying step, the mist is carried with the carrier gas and the dilution carrier gas from the mist-generating member 220 to a nozzle in the film-forming member 215 through the supplying pipe 209 coupling the mist-generating member 220 and the film-forming member 215.

### (Film-Forming Step)

As the film-forming step, the mist and the carrier gas carried to the nozzle are jetted onto the substrate 210, and the substrate 210 is heated for allowing a thermal reaction to form a film on a surface of the substrate 210.

In the film-forming step, the gas other than the carrier gas is not necessarily fed, but the film formation while feeding the gas other than the carrier gas can more reduce the particle density on the obtained film. In addition, contamination in the film with a foreign matter is inhibited, and thereby the crystallinity is also more improved. Further, the mist is appropriately dispersed on the substrate, and thereby the film thickness distribution is also improved.

The substrate 210 or the nozzle may be coupled to a conveying mechanism to form a movable configuration such as reciprocating motion and rotating motion during the film formation. Performing these moving operations can further improve uniformity of the obtained film.

The thermal reaction of the mist also depends on the environment temperature around the substrate. Therefore, temperatures of the nozzle and the inner wall of the film-forming member 215 are desirably higher than room temperature. This setting can stabilize the thermal reaction. The nozzle temperature may be, for example, 50°C to 250°C.

The thermal reaction may be performed under any atmosphere of a non-oxygen atmosphere, a reductive-gas atmosphere, an air atmosphere, and an oxygen atmosphere, which may be appropriately set according to the film to be formed. Regarding a reaction pressure, the reaction may be performed under any conditions of an atmospheric pressure, an increased pressure, and a reduced pressure, and the film formation under an atmospheric pressure is preferable because the apparatus configuration can be simplified.

### (Thermal Treatment)

The laminated structure produced with the film-forming method and film-forming apparatus of the present invention may be subjected to a thermal treatment at 200 to 600°C. This thermal treatment further removes unreacted species in the film to yield a laminated structure with higher quality. The thermal treatment may be performed in air or an oxygen atmosphere, or may be performed under an inert gas atmosphere such as nitrogen and argon. The thermal treatment time may be appropriately decided, and may be 5 to 240 minutes, for example.

### (Release)

In the laminated structure produced with the film-forming method and film-forming apparatus of the present invention, the crystalline oxide film may be peeled from the base substrate. The releasing means is not particularly limited, and may be a known means. Examples of the method for the releasing means include a releasing means of applying mechanical impact, a releasing means of applying heat to utilize thermal stress, a releasing means of applying vibration such as ultrasonic wave, and a releasing means of etching. These releasing means can yield the crystalline oxide film as a freestanding film.

### (Crystalline Oxide Film)

The laminated structure produced with the film-forming method and film-forming apparatus of the present invention has a density of particles having a diameter of 0.3 µm or more on the surface of the crystalline oxide film of 50 /cm² or less. The particles having a diameter of 0.3 µm or more considerably affect the properties when semiconductor devices are produced from the crystalline oxide film. The crystalline oxide film having the above density of particles having a diameter of 0.3 µm or more is a high-quality film suitable for producing semiconductor devices.

The term "particles on the substrate" in the present invention includes particles incorporated in the crystalline oxide film and integrated with the film and particles adhering to the crystalline oxide film surface as a foreign matter, and refers to an object observed as particles when the film surface is observed.

The diameter of the particles on the substrate is a value based on a particle size measured with a light-scattering particle measurement device. The particle size is determined by calibrating the measurement device with standard particles with a plurality of sizes. That is, the diameter is a value classified by comparison between the measured value of measuring the particles with the measurement device and the measured values of measuring the standard particles. The particles on the surface of the crystalline oxide film can be measured by using a laser-scattering particle counter, for example. The particles on the surface can also be determined by observing the film surface using an optical microscope for counting by size. For example, the particles on the substrate with about 0.3 to 100 µm can be observed by setting of a dark field and a magnification of 50 etc.

The crystalline oxide film is typically composed of a metal and oxygen, and the crystalline oxide film according to the present invention preferably contains gallium as a main component of the metal. The phrase "mainly containing gallium oxide" in the present invention means that 50 to 100% of the metal component is gallium. As a metal component other than gallium, one or two or more metals selected from iron, indium, aluminum, vanadium, titanium, chromium, rhodium, iridium, nickel, and cobalt may be contained, for example.

The crystalline oxide film may contain a dopant element. Examples thereof include, but not particularly limited to: n-type dopants such as tin, germanium, silicon, titanium, zirconium, vanadium, or niobium; or p-type dopants such as copper, silver, tin, iridium, rhodium, or magnesium. A concentration of the dopant may be, for example, about 1×10¹⁶ /cm³ to 1×10²² /cm³, a low concentration of about 1×10¹⁷ /cm³ or less, or a high concentration of about 1×10²⁰ /cm³ or more.

The crystal structure of the crystalline oxide film is not particularly limited, and may be a β-gallia structure, a corundum structure, or an orthorhombic crystal. A plurality of crystal structures may be present or may be a polycrystal, but the crystalline oxide film is preferably a single crystal or a monoaxially oriented film. Being the single crystal or the monoaxially oriented film can be confirmed with an X-ray diffraction device or an electron beam diffraction device. The film irradiated with X-ray or electron beam yields a diffraction image depending on the crystal structure, and the monoaxial orientation generates only a specific peak. From this peak, it can be determined that the film is monoaxially oriented.

A film thickness of the crystalline oxide film is not particularly limited, but preferably 0.1 µm or more. The upper limit is not particularly limited. The film thickness may be, for example, 100 µm or less, preferably 50 µm or less, and may be more preferably 30 µm or less. The film thickness can be measured with a probe-type step profiler, a reflective spectroscopic film thickness meter, an ellipsometer, a method of observing the cross section with an SEM or a TEM, etc., and any method may be used.

The crystalline oxide film as above can be obtained by the film formation with the mist-CVD method using the mist-CVD apparatus (the film-forming apparatus).

### (α-Ga₂O₃ Film)

Specific examples of the crystalline oxide film include an α-Ga₂O₃ film.

The α-Ga₂O₃ film has, for example, a film-thickness variation of 3.3% or less and particles on the film at 29 /cm² or less, the particles being observed with an optical microscope.

The α-Ga₂O₃ film as above has excellent film-thickness distribution, and inhibited contamination inside the film with a foreign matter. Thus, the α-Ga₂O₃ film is a high-quality film with an extremely reduced particle density on the film surface, which is suitable for producing a semiconductor device.

Since a smaller film-thickness variation is better, the lower limit is preferably 0%. In addition, since a smaller amount of the particles on the film is better, the lower limit is preferably 0 /cm².

In the α-Ga₂O₃ film, a half-value width of a rocking curve on a (006) plane by X-ray diffraction is preferably 8 seconds or less.

The α-Ga₂O₃ film as above has good crystallinity. Since a smaller half-value width is better, the lower limit is more than 0 seconds.

The α-Ga₂O₃ film preferably has a diameter of 4 inch (100 mm) to 8 inch (200 mm).

The α-Ga₂O₃ film as above is a high-quality film with a more remarkably reduced particle density on the film surface also on a large-area substrate.

### (Formation of Buffer Layer)

A buffer layer may be appropriately provided between the substrate and the crystalline oxide film. A method for forming the buffer layer is not particularly limited, and the buffer layer may be formed by a known method such as sputtering and vapor deposition. When the mist-CVD method is used, the buffer layer can be formed only by appropriately changing the raw material solution, which is convenient. Specifically, one or two or more metals selected from aluminum, gallium, chromium, iron, indium, rhodium, vanadium, titanium, and iridium dissolved or dispersed in water as a complex form or a salt form can be suitably used as a raw material aqueous solution. Examples of the complex form include an acetylacetonate complex, a carbonyl complex, an ammine complex, and a hydride complex. Examples of the salt form include a metal chloride salt, a metal bromide salt, and a metal iodide salt. A solution in which the above metal is dissolved in hydrobromic acid, hydrochloric acid, hydroiodic acid, etc. may also be used as the aqueous salt solution. In this case, the solute concentration is also preferably 0.005 to 1 mol/L, and the dissolution temperature is preferably 20°C or higher. The buffer layer can be formed by setting the other conditions to be the same as above. The buffer layer is formed with a predetermined thickness, and then the film is formed by the aforementioned method.

A special case of the method for forming the buffer layer includes a case of using a material same as the crystalline oxide film. In this case, the film-forming temperature for the buffer layer may be higher than the film-forming temperature for the crystalline oxide film. For example, the film-forming temperature for the buffer layer may be 450°C and the film-forming temperature for the crystalline oxide film may be 400°C, or the temperature for the buffer layer may be 500°C and the temperature for the crystalline oxide film may be 450°C, etc. Setting as above more increases the crystallinity of the crystalline oxide film.

### (Semiconductor Device)

FIG. 2 is a schematic diagram illustrating an example of a semiconductor device using the laminated structure including the crystalline oxide film produced with the film-forming method and film-forming apparatus of the present invention.

As illustrated in FIG. 2, a semiconductor device 100 using the laminated structure including the crystalline oxide film produced with the film-forming method and film-forming apparatus of the present invention has a laminated structure 110 in which a crystalline oxide film 103 is laminated on a base substrate 101, and in the crystalline oxide film 103, a conductive thin film 103b is laminated on an insulative thin film 103a. On the conductive thin film 103b, a gate insulative film 105 is formed. On the gate insulative film 105, a gate electrode 107 is formed. Further, on the conductive thin film 103b, source-drain electrodes 109 are formed so as to sandwich the gate electrode 107. This configuration enables to control a depletion layer formed in the conductive thin film 103b with a gate voltage applied to the gate electrode 107 to enable transistor operation (an FET device).

This semiconductor device 100 can be utilized for transistors such as MIS, HEMT, and IGBT, a Schottky barrier diode utilizing TFT and semiconductor-metal joint, a PN or PIN diode combined with another P layer, and a light receiving or emitting element. The crystalline oxide film formed with the film-forming method and film-forming apparatus of the present invention can be a high-quality crystal film, and can be useful for improving properties of these devices.

### (Second Embodiment of the Present Invention)

Hereinafter, a film-forming apparatus according to the second embodiment of the present invention will be described.

FIG. 3 is a schematic diagram illustrating another example of the film-forming member of the film-forming apparatus of the present invention.

As illustrated in FIG. 3, the film-forming apparatus according to the second embodiment of the present invention has a configuration same as of the film-forming apparatus according to the first embodiment of the present invention except that the position of the gas-feeding member 501 is changed from the ceiling to the side wall.

This configuration also allows the gas through the gas-feeding member 501 to reduce a number of the aerial particles in the film-forming member, which can generate the high-quality crystal film.

### (Third Embodiment of the Present Invention)

Hereinafter, a film-forming apparatus according to the third embodiment of the present invention will be described.

FIG. 4 is a schematic diagram illustrating further another example of the film-forming member of the film-forming apparatus of the present invention.

As illustrated in FIG. 4, the film-forming apparatus according to the third embodiment of the present invention has a configuration same as of the film-forming apparatus according to the first embodiment of the present invention except that the gas-discharging member 511 is provided so as to surround the partition wall (the film-forming chamber) 207, and the gas is discharged from the partition wall (the film-forming chamber) 207 through the gas-discharging member 511.

This configuration also allows the gas through the gas-feeding member 501 to reduce a number of the aerial particles in the film-forming member, which can generate the high-quality crystal film. In particular, the number of the aerial particles in the film-forming member can be more reduced by setting the pressure in the film-forming member to be positive and setting the pressure in the gas-discharging member to be negative.

### (Fourth Embodiment of the Present Invention)

Hereinafter, a film-forming apparatus according to the fourth embodiment of the present invention will be described.

FIG. 5 is a schematic diagram illustrating furthermore another example of the film-forming member of the film-forming apparatus of the present invention.

As illustrated in FIG. 5, the film-forming apparatus according to the fourth embodiment of the present invention has a configuration same as of the film-forming apparatus according to the third embodiment of the present invention except that the partition wall of the bottom surface of the partition wall (the film-forming chamber) 207 is absent, and the bottom surface portion forms a huge gas-discharging port.

This configuration also allows the gas through the gas-feeding member 501 to reduce a number of the aerial particles in the film-forming member, which can generate the high-quality crystal film. In particular, the number of the aerial particles in the film-forming member can be more reduced with the huge gas-discharging port.

### (Fifth Embodiment of the Present Invention)

Hereinafter, a film-forming apparatus according to the fifth embodiment of the present invention will be described.

FIG. 6 is a schematic diagram illustrating still furthermore another example of the film-forming member of the film-forming apparatus of the present invention.

As illustrated in FIG. 6, the film-forming apparatus according to the fifth embodiment of the present invention has a configuration same as of the film-forming apparatus according to the fourth embodiment of the present invention except that the ceiling of the partition wall (the film-forming chamber) 207 and the gas-discharging member 511 become common.

This configuration also allows the gas through the gas-feeding member 501 to reduce a number of the aerial particles in the film-forming member, which can generate the high-quality crystal film.

### EXAMPLE

Hereinafter, the present invention will be specifically described with Examples, but the Examples do not limit the present invention.

### Example 1

With the film-forming apparatus 201 illustrated in FIG. 1, a film was formed in the partition wall (the film-forming chamber) 207.

The film-forming apparatus 201 has the carrier gas source 202a configured to supply a carrier gas, the flow-rate regulating valve 203a for regulating a flow rate of the carrier gas fed from the carrier gas source 202a, the dilution carrier gas source 202b configured to supply a dilution carrier gas, the flow-rate regulating valve 203b for regulating a flow rate of the dilution carrier gas fed from the dilution carrier gas source 202b, the mist-generating source 204 configured to contain the raw material solution 204a, the container 205 containing water 205a, and the ultrasonic wave vibrator 206 attached to the bottom surface of the container 205.

The partition wall (the film-forming chamber) 207 has the heater 208 and the quartz supplying pipe 209 coupling the mist-generating source 204 and the film-forming member 215. A fan (the gas-feeding member 501) was provided on the ceiling of the partition wall (the film-forming chamber) 207, and clean air passed through a HEPA filter was supplied into the partition wall (the film-forming chamber) 207.

Particles in the partition wall (the film-forming chamber) 207 during the gas feeding was measured by using a particle counter KC-31, available from RION CO., LTD., and the number of particles having a particle diameter of 0.3 µm was 12830 /m³.

### (Formation of Gallium Oxide Film)

A gallium oxide film was formed by using this apparatus.

As the substrate 210, a c-plane sapphire substrate with 4 ich (100 mm) was prepared.

This substrate was placed in the partition wall (the film-forming chamber) 207, the heater 208 was set to 450°C to rise the temperature, and retained for 30 minutes to stabilize the temperature in the partition wall (the film-forming chamber) 207 including the nozzle.

For the raw material solution 204a, ultrapure water was used as the solvent, and gallium bromide was used as the solute. A gallium concentration in the raw material solution was 0.1 mol/L.

This raw material solution 204a was contained in the mist-generating source 204.

Subsequently, the flow-rate regulating valves 203a and 203b were opened to supply the carrier gas from the carrier gas sources 202a and 202b into the partition wall (the film-forming chamber) 207, the atmosphere in the partition wall (the film-forming chamber) 207 was sufficiently substituted with the carrier gas, and then the flow rate of the carrier gas was regulated to 4 NL/min and the flow rate of the dilution carrier gas was regulated to 6 NL/min. As the carrier gas, nitrogen was used.

Then, the ultrasonic wave vibrator 206 was vibrated at 2.4 MHz, and the vibration was propagated through water 205a to the raw material solution 204a to atomize the raw material solution 204a into a mist to generate the mist. This mist was introduced into the partition wall (the film-forming chamber) 207 with the carrier gas through the supplying pipe 209, and the mist was subjected to the thermal reaction on the substrate 210 to form a thin film of gallium oxide on the substrate 210. The film-forming time was 30 minutes.

### (Evaluation)

As for the thin film formed on the substrate 210, formation of α-Ga₂O₃ was confirmed by X-ray diffraction.

A rocking curve on a (006) plane of α-Ga₂O₃ was measured, and the half-value width was 8 seconds, which was extremely good crystallinity. For measuring the rocking curve, monochromaticity of X-ray was improved by using a four-crystal monochromator combining two channel cut crystals to perform the measurement with higher accuracy. Other measurement conditions were as follows.

| | | |
|---|---|---|
| Measurement Conditions | | |
| Measurement apparatus: | SmartLab available from Rigaku Corporation | |
| Analysis condition: | | |
| Measurement method: | Rocking curve measurement (ω-scanning) | |
| X-ray generator: | Anticathode Cu | |
| | Output | 45 kV, 200 mA |
| Detector: | Semiconductor detector | |
| Incident optical system: | Ge (220) channel cut monochromator | |
| Solar slit: | Incident side | - |
| | Light-receiving side | 5.0° |
| Slit: | Incident side | IS = 1 (mm) |
| | Longitudinal limit | 0.5 (mm) |
| | Light-receiving side | RS1 = 1, RS2 = 1.1 (mm) |
| Scanning condition: | Evaluated diffraction plane Ga₂O₃(006) | |
| | Scanning axis | ω |
| | Scanning mode | Step measurement |
| | Scanning range | 18 to 22° |
| | Step width | 0.005° |
| | Integration time | 0.5 sec/step |

Then, the film thickness was measured at 25 points with a reflective spectrometric film thickness meter F50, available from Filmetrics, INC., and the average film thickness was 571 nm.

Further, the film-thickness variation, determined by (Maximum film thickness - Minimum film thickness) / (Maximum film thickness + Minimum film thickness) × 100 (%), was 2.9%, which was good.

By using an optical microscope, observation was performed at 69 points in the substrate surface with a magnification of 50 to determine presence or absence of particles on the film. As a result, no particles were detected within the observation range. A particle density was calculated from the observation range to be 29 /cm² or less.

### Example 2

A film was formed and evaluated under the same condition by the same method as of Example 1 except that the partition wall (the film-forming chamber) 207 was replaced with that in FIG. 3.

### Example 3

A film was formed and evaluated under the same condition by the same method as of Example 1 except that the partition wall (the film-forming chamber) 207 was replaced with that in FIG. 4, and the gas was also forcedly discharged through the gas-discharging port 512.

### Example 4

A film was formed and evaluated under the same condition by the same method as of Example 3 except that the partition wall (the film-forming chamber) 207 was replaced with that in FIG. 5.

### Example 5

A film was formed and evaluated under the same condition by the same method as of Example 3 except that the partition wall (the film-forming chamber) 207 was replaced with that in FIG. 6.

### Comparative Example

A film was formed and evaluated under the same condition by the same method as of Example 1 except that the gas-feeding member (the fan) was not provided on the ceiling of the partition wall (the film-forming chamber) 207 to not feed air.

Table 1 shows the evaluation results of Examples 1 to 5 and Comparative Example.

**[Table 1]**

| | Aerial particles in film-forming member (/m³) | Rocking curve half-value width (sec) | Film thickness (nm) | Film thickness distribution (±%) | Particle on film (/cm²) |
|---|---|---|---|---|---|
| Example 1 | 12830 | 8 | 571 | 2.9 | ≤29 |
| Example 2 | 9510 | 7 | 587 | 3.3 | ≤29 |
| Example 3 | 9270 | 8 | 566 | 2.5 | ≤29 |
| Example 4 | 9940 | 8 | 570 | 3.0 | ≤29 |
| Example 5 | 10250 | 6 | 583 | 2.7 | ≤29 |
| Comparative Exmaple | 147160 | 25 | 590 | 4.0 | 355 |

As above, Examples 1 to 5 of the present invention were able to reduce the aerial particles compared with Comparative Example. According to this, it was found that particles to adhere onto the film were dramatically reduced.

Examples 1 to 5 were also able to reduce the half-value width of the rocking curve compared with Comparative Example. According to this, it was found that the crystallinity was also improved. This was presumably because contamination inside the film with a foreign matter was inhibited.

The film thickness distribution was also improved. This was presumably because feeding air into the film-forming chamber appropriately dispersed the mist on the substrate.

The present description includes the following embodiments.
[1]: A film-forming method for forming a crystalline oxide film by a mist-CVD method, the method comprising:
   supplying a mist together with a carrier gas onto a heated substrate in a film-forming member covered with a partition wall,
   wherein, in at least heating the substrate, a gas other than the carrier gas is fed into the film-forming member.
[2]: The film-forming method according to the above [1], wherein, in not supplying the mist, a density of particles having a particle diameter of 0.3 µm or more in the film-forming member is 100000 /m³ or less.
[3]: The film-forming method according to the above [1] or [2], wherein air is used as the gas other than the carrier gas.
[4]: A film-forming method for forming a crystalline oxide film by a mist-CVD method, the method comprising:
   supplying a mist together with a carrier gas onto a heated substrate in a film-forming member covered with a partition wall,
   wherein, in at least not supplying the mist, a density of particles having a particle diameter of 0.3 µm or more in the film-forming member is 100000 /m³ or less.
[5]: The film-forming method according to any one of the above [1] to [4], wherein
   a gas-discharging member is provided so as to surround the film-forming member, and
   a gas is discharged from the film-forming member through the gas-discharging member.
[6]: The film-forming method according to the above [5], wherein a flow rate of the gas discharged through the gas-discharging member is larger than a flow rate of the carrier gas.
[7]: The film-forming method according to any one of the above [1] to [6], wherein a substrate having a diameter of 4 inch (100 mm) to 8 inch (200 mm) is used as the substrate.
[8]: A film-forming apparatus, comprising:
   a film-forming member covered with a partition wall;
   a carrier gas-supplying member; and
   a mist-generating member configured to generate a mist, wherein
   the film-forming apparatus is configured to supply the mist together with a carrier gas into the film-forming member and to form a film, and
   a gas-feeding member is provided on the film-forming member for feeding a gas other than the carrier gas.
[9]: The film-forming apparatus according to the above [8], wherein a filter is provided on the gas-feeding member.
[10]: The film-forming apparatus according to the above [8] or [9], wherein
   a gas-discharging member is provided so as to surround the film-forming member, and
   a gas is discharged from the film-forming member through the gas-discharging member.
[11]: The film-forming apparatus according to any one of the above [8] to [10], wherein the gas-feeding member is configured to feed air as the gas other than the carrier gas.
[12]: An α-Ga₂O₃ film having a film-thickness variation of 3.3% or less and particles on the film at 29 /cm² or less, the particles being observed with an optical microscope.
[13]: The α-Ga₂O₃ film according to the above [12], wherein a half-value width of a rocking curve on a (006) plane by X-ray diffraction is 8 seconds or less.
[14]: The α-Ga₂O₃ film according to the above [12] or [13], wherein the film has a diameter of 4 inch (100 mm) to 8 inch (200 mm).

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A film-forming method for forming a crystalline oxide film by a mist-CVD method, the method comprising:
supplying a mist together with a carrier gas onto a heated substrate in a film-forming member covered with a partition wall,
wherein, in at least heating the substrate, a gas other than the carrier gas is fed into the film-forming member.

2. The film-forming method according to claim 1, wherein, in not supplying the mist, a density of particles having a particle diameter of 0.3 µm or more in the film-forming member is 100000 /m³ or less.

3. The film-forming method according to claim 1, wherein air is used as the gas other than the carrier gas.

4. A film-forming method for forming a crystalline oxide film by a mist-CVD method, the method comprising:
supplying a mist together with a carrier gas onto a heated substrate in a film-forming member covered with a partition wall,
wherein, in at least not supplying the mist, a density of particles having a particle diameter of 0.3 µm or more in the film-forming member is 100000 /m³ or less.

5. The film-forming method according to claim 1 or 4, wherein
a gas-discharging member is provided so as to surround the film-forming member, and
a gas is discharged from the film-forming member through the gas-discharging member.

6. The film-forming method according to claim 5, wherein a flow rate of the gas discharged through the gas-discharging member is larger than a flow rate of the carrier gas.

7. The film-forming method according to any one of claims 1 to 4, wherein a substrate having a diameter of 4 inch (100 mm) to 8 inch (200 mm) is used as the substrate.

8. A film-forming apparatus, comprising:
a film-forming member covered with a partition wall;
a carrier gas-supplying member; and
a mist-generating member configured to generate a mist, wherein
the film-forming apparatus is configured to supply the mist together with a carrier gas into the film-forming member and to form a film, and
a gas-feeding member is provided on the film-forming member for feeding a gas other than the carrier gas.

9. The film-forming apparatus according to claim 8, wherein a filter is provided on the gas-feeding member.

10. The film-forming apparatus according to claim 8, wherein
a gas-discharging member is provided so as to surround the film-forming member, and
a gas is discharged from the film-forming member through the gas-discharging member.

11. The film-forming apparatus according to any one of claims 8 to 10, wherein the gas-feeding member is configured to feed air as the gas other than the carrier gas.

12. An α-Ga₂O₃ film having a film-thickness variation of 3.3% or less and particles on the film at 29 /cm² or less, the particles being observed with an optical microscope.

13. The α-Ga₂O₃ film according to claim 12, wherein a half-value width of a rocking curve on a (006) plane by X-ray diffraction is 8 seconds or less.

14. The α-Ga₂O₃ film according to claim 12 or 13, wherein the film has a diameter of 4 inch (100 mm) to 8 inch (200 mm).
